# FASCICULE DE BREVET EUROPEEN

(11) **EP 3 751 356 B1**
(45) Date de publication et mention de la délivrance du brevet: **21.12.2022**
(21) Numéro de dépôt: 20162701.5
(22) Date de dépôt: 12.03.2020
(51) Int. Cl.: C22C 9/02, C23C 14/16, C23C 18/48, C25D 1/02, C25D 7/00, G04B 13/02, G04B 29/02, G04B 37/22, G04B 15/14, C23C 18/16

(54) **COMPOSANT HORLOGER PERFECTIONNÉ**
PERFEKTIONIERTE UHR KOMPONENTE
IMPROVED TIMEPIECE COMPONENT

(30) Priorité: 14.03.2019 CH 3062019
(43) Date de publication de la demande: 16.12.2020
(73) Titulaire: Richemont International S.A., 1752 Villars-sur-Glâne (CH)
(72) Inventeur: GOUIDER, Mohamed, 2000 Neuchâtel (CH); ROLLAND, Julian, 01280 Prévessin-Moens (FR); FIACCABRINO, Jean-Charles, 1421 Grandevent (CH); DIABY, Moussa, 78330 Fontenay le Fleury (FR)
(74) Mandataire: LLR

(56) Documents cités:
- EP-A1- 3 098 670
- EP-A1- 3 385 795
- WO-A1-2015/039152
- WO-A1-2018/172895
- DE-C1- 3 500 555
- US-A1- 2004 093 730

## Description

### DOMAINE TECHNIQUE DE L'INVENTION

La présente invention se rapporte à un composant tel qu'une pièce de micromécanique ou une pièce d'habillage d'une pièce d'horlogerie.

### ARRIÈRE-PLAN TECHNIQUE DE L'INVENTION

Les mouvements horlogers, particulièrement ceux mécaniques, utilisent beaucoup de pièces en frottement les unes contre les autres ce qui induit des pertes d'énergie, voire de l'usure même en présence de lubrifiant.

Il est donc constamment recherché des pièces de micromécanique dont les propriétés tribologiques sont les meilleures possibles. On connaît par exemple EP 3 385 795 A1, qui divulgue des composants de pièce d'horlogerie en alliage Cu-Sn-Zn.

### RÉSUMÉ DE L'INVENTION

L'invention a pour but de proposer un nouveau type de matériau pour un composant par exemple de pièce d'horlogerie permettant des propriétés tribologiques améliorées notamment en offrant un coefficient de frottement et une résistance à l'usure améliorés.

À cet effet, l'invention se rapporte à un composant pour une pièce d'horlogerie, **caractérisé en ce qu**'il comporte un alliage du type galvanique ou du type dépôt autocatalytique à base de cuivre, d'étain et de zinc permettant des propriétés tribologiques améliorées et **en ce que** le composant est formé à partir de l'alliage qui comporte une proportion de cuivre majoritaire en pourcentage de la masse totale de l'alliage, une proportion de zinc minoritaire en pourcentage de la masse totale de l'alliage et une proportion d'étain intermédiaire entre la proportion de cuivre et la proportion de zinc en pourcentage de la masse totale de l'alliage.

Selon l'invention, il a été trouvé qu'un tel alliage ternaire réunit un certain nombre d'avantages. Ainsi, il a été trouvé que le coefficient de frottement et la résistance à l'usure d'un tel alliage sont particulièrement intéressants, notamment par rapport à des matériaux à base de nickel ou de nickel-phosphore utilisés actuellement en horlogerie. De plus, bien qu'il puisse comporter une majorité de cuivre, il présente un aspect gris métallique offrant une esthétique avantageuse, des caractéristiques élastiques (comme le module d'élasticité et la limite élastique) et une dureté étonnamment élevées pour un alliage à base de cuivre. En outre, un tel alliage possède une très faible susceptibilité magnétique, c'est-à-dire qu'il est très peu sensible aux champs magnétiques. Enfin, cet alliage est inoxydable. On comprend donc que l'alliage mis en œuvre selon l'invention a toutes les qualités pour une application horlogère.

L'alliage est préférentiellement du type galvanique afin d'améliorer sa dureté. En effet, il a été trouvé que ce même alliage comporte une dureté inférieure quand il est fabriqué selon un autre procédé.

Enfin, bien qu'il comporte une majorité de cuivre, l'alliage offre un aspect gris métallique offrant une esthétique avantageuse.

L'invention peut également comporter l'une ou plusieurs des caractéristiques optionnelles suivantes, prises seules ou en combinaison.

La proportion de cuivre majoritaire est comprise entre 50 et 85 %, la proportion d'étain intermédiaire est comprise entre 10 et 40 % et la proportion de zinc minoritaire est comprise entre 2 et 15 % et, de manière préférée, la proportion de cuivre majoritaire est comprise entre 55 et 65 %, la proportion d'étain intermédiaire est comprise entre 25 et 40 % et la proportion de zinc minoritaire est comprise entre 4 et 10 %.

Selon une première variante, la proportion de cuivre majoritaire est sensiblement égale à 65 %, la proportion d'étain intermédiaire est sensiblement égale à 30 % et la proportion de zinc minoritaire est sensiblement égale à 5 %. Selon une deuxième variante, la proportion de cuivre majoritaire est sensiblement égale à 60 %, la proportion d'étain intermédiaire est sensiblement égale à 30 % et la proportion de zinc minoritaire est sensiblement égale à 10 %. Selon une troisième variante, la proportion de cuivre majoritaire est sensiblement égale à 57 %, la proportion d'étain intermédiaire est sensiblement égale à 39 % et la proportion de zinc minoritaire est sensiblement égale à 4 %.

Typiquement, l'épaisseur du composant peut, par exemple, être comprise entre 10 µm et 1 mm et, de manière préférée, entre 100 µm et 800 µm.

Selon un premier mode de réalisation, le composant selon l'invention est entièrement formé à partir de l'alliage susmentionné. On comprend donc que le composant peut être obtenu par exemple par électroformage. De fait, toute la surface extérieure du composant est formée à partir de l'alliage.

Selon un deuxième mode de réalisation, le composant selon l'invention est principalement formé à partir de l'alliage susmentionné par exemple par électroformage. L'alliage est au moins partiellement revêtu par un matériau autre que l'alliage. On comprend donc que le composant peut être obtenu par un dépôt en surépaisseur d'un matériau autre que l'alliage, par exemple par galvanoplastie ou dépôt en phase vapeur, sur tout ou partie de l'alliage préalablement fabriqué. De fait, l'alliage à base de cuivre, d'étain et de zinc peut être uniquement partiellement ou totalement revêtue, par un matériau autre que l'alliage à base de cuivre, d'étain et de zinc.

De plus, l'invention se rapporte à une pièce d'horlogerie comportant au moins un composant, **caractérisée en ce que** le composant est tel que décrit plus haut. Un tel composant peut ainsi être une pièce de micromécanique ou une pièce d'habillage.

### BRÈVE DESCRIPTION DES DESSINS

D'autres particularités et avantages de l'invention ressortiront clairement de la description qui en est faite ci-après, à titre indicatif et nullement limitatif, en référence aux dessins annexés, dans lesquels :
- La figure 1 est une vue schématique d'une pièce d'horlogerie selon l'invention ;
- La figure 2 est une vue en perspective d'un composant selon l'invention ;
- La figure 3A est une vue en coupe d'un premier mode de réalisation selon le plan III-III de la figure 2 ;
- La figure 3B est une vue en coupe d'une première variante d'un deuxième mode de réalisation selon le plan III-III de la figure 2 ;
- La figure 3C est une vue en coupe d'une deuxième variante du deuxième mode de réalisation selon le plan III-III de la figure 2.

### DESCRIPTION DÉTAILLÉE D'AU MOINS UN MODE DE RÉALISATION DE L'INVENTION

Par « pièce d'horlogerie », on entend tous les types d'instruments de mesure ou de comptage du temps tels que les pendules, les pendulettes et les montres.

Par « mouvement horloger », on entend tous les types de mécanisme capables de compter le temps qu'ils soient alimentés à base d'énergie mécanique (par exemple un barillet) ou électrique (par exemple une batterie).

Par « pièce de micromécanique », on entend tous les types de pièces utilisables dans une pièce d'horlogerie notamment pour former son mouvement horloger.

Par « habillage », on entend tous les types de dispositifs capables de contenir, afficher, décorer et/ou commander un mouvement horloger comme, par exemple, tout ou partie d'une boîte, d'un bracelet ou d'un affichage.

Dans ce qui suit, sauf indication contraire, tous les pourcentages (%) indiqués sont des pourcentages en masse totale ou poids (en anglais « weight »).

L'invention se rapporte à un composant 1 pour une pièce d'horlogerie 11. Un tel composant 1 peut ainsi être une pièce de micromécanique ou une pièce d'habillage 13. Plus précisément, le composant 1 peut former tout ou partie d'un habillage comme tout ou partie d'un cadran, d'un affichage tel qu'une aiguille ou un disque, d'une boîte, d'un bracelet, d'une glace ou d'un organe de commande tel qu'une couronne ou un boutonpoussoir. Le composant 1 peut également former tout ou partie d'un mouvement horloger comme tout ou partie d'un dispositif d'échappement tel qu'un mécanisme à ancre suisse, d'un résonateur tel qu'un mécanisme balancier - spiral, d'une source d'énergie tel qu'un barillet, un système de remontage automatique ou une batterie, d'un rouage tel qu'un mobile ou une roue dentée, d'un ressort, d'une vis, d'un pont ou d'une platine.

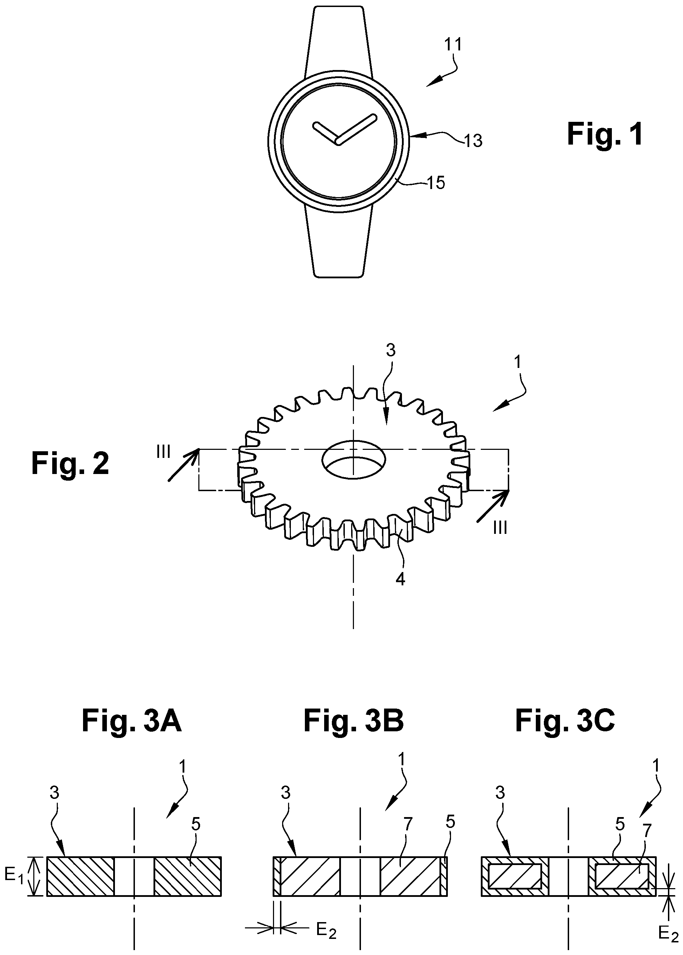

À titre nullement limitatif, le composant 1 peut former un élément d'un rouage (comme une roue 3 dentée à la figure 2) notamment de finissage (remplacement notamment d'une pièce rhodiée), d'une platine, d'un pont, d'un système de remontage, d'un échappement, d'un boîtier 15 ou d'un barillet (remplacement notamment d'une pièce nickelée). Par exemple, le composant 1 peut former un tenon guidant des renvois ou un pignon de remontoir d'un remontage manuel, un mobile d'armage ou un axe (par exemple excentrique) d'un remontage automatique, un axe (par exemple de balancier, de mobile ou de roue), une tirette, un pignon coulant ou un pignon de système de mise à l'heure ou une vis. Enfin, le composant 1 pourrait également former une pièce de mécanisme comme une came, un sautoir, une étoile, un doigt, un puiseur ou une vis.

De manière préférée, le composant 1 est une pièce active, c'est-à-dire une pièce destinée à transmettre un mouvement et, incidemment, destinée à subir un frottement avec une autre pièce. En effet, l'invention se proposant d'améliorer les propriétés tribologiques du composant 1, elle vise préférentiellement un composant 1 qui est en contact au moins temporairement pendant son déplacement avec un autre élément.

Avantageusement selon l'invention, le composant 1 est formé à partir d'un alliage 5 à base de cuivre, d'étain et de zinc permettant des propriétés tribologiques améliorées.

En effet, il a été trouvé qu'un tel alliage 5 réunit un certain nombre d'avantages. Ainsi, il a été trouvé qu'un tel alliage 5 présente un coefficient de frottement et une résistance à l'usure améliorés notamment par rapport à des matériaux à base de nickel ou de nickel-phosphore utilisés actuellement en horlogerie. De plus, bien qu'il puisse comporter une majorité de cuivre, il présente un aspect gris métallique offrant une esthétique avantageuse, des caractéristiques élastiques (comme le module d'élasticité et la limite élastique) et une dureté étonnamment élevées pour un alliage à base de cuivre. En outre, un tel alliage 5 possède une très faible susceptibilité magnétique, c'est-à-dire qu'il est très peu sensible aux champs magnétiques. Enfin, cet alliage 5 est inoxydable. L'alliage 5 selon l'invention est donc particulièrement avantageux pour une application notamment horlogère.

Selon un premier mode de réalisation, le composant 1 selon l'invention est entièrement formé à partir de l'alliage 5 comme illustré aux exemples des figures 2 et 3A. On comprend donc que le composant 1 peut être obtenu par exemple par électroformage (fabrication d'un moule suivie du remplissage du moule par dépôt électrolytique), par dépôt autocatalytique (en anglais « electroless plating ») ou dépôt en phase vapeur (physique ou chimique). Un tel composant 1 peut donc remplacer des pièces massives, c'est-à-dire, par exemple, des pièces comportant une épaisseur E₁ comprise entre 10 *µ*m et 1 mm et, de manière préférée, entre 100 *µ*m et 800 *µ*m, usuellement à base d'acier, de nickel ou un de ses alliages, de CuBe ou de laiton en apportant tous les avantages de l'alliage 5 expliqués ci-dessus.

Selon un deuxième mode de réalisation n'appartenant pas à l'invention, le composant 1 est formé par au moins une pièce 7 au moins partiellement revêtue par l'alliage 5 comme illustré aux exemples des figures 2, 3B et 3C. On comprend donc que le composant 1 peut être obtenu par un dépôt en surépaisseur de l'alliage 5, c'est-à-dire par exemple une épaisseur E₂ comprise entre 0,1 *µ*m et 10 *µ*m, de manière préférée, entre 0,3 *µ*m et 5 *µ*m, et, de manière encore plus préférée, entre 0,5 *µ*m et 2 *µ*m, sur tout ou partie de la pièce 7 préalablement fabriquée, par exemple par galvanoplastie (dépôt électrolytique), par dépôt autocatalytique ou par dépôt en phase vapeur (physique ou chimique). Un tel revêtement d'alliage 5 peut être par conséquent déposé sur une pièce 7 non revêtue habituellement ou en remplacement d'un revêtement habituellement utilisé, par exemple à base de nickel ou un de ses alliages tel du nickel-phosphore, d'or ou de rhodium.

Dans une première variante du deuxième mode de réalisation illustré à la figure 3B, l'alliage 5 est présent uniquement à la périphérie de la roue 3 dentée afin d'améliorer les propriétés tribologiques de la denture 4. De fait, au moins une autre partie de la surface extérieure du composant 1 n'est donc pas formée à partir de l'alliage 5. Bien entendu, l'alliage 5 pourrait être présent sur plus ou moins de face du composant 1. Ainsi, dans une deuxième variante du deuxième mode de réalisation illustré à la figure 3C, l'alliage 5 recouvre totalement la pièce 7 afin d'améliorer les qualités de la totalité du composant 1.

Selon un troisième mode de réalisation (non illustré car sensiblement inverse au deuxième mode de réalisation), le composant 1 selon l'invention est principalement formé à partir de l'alliage 5 à base de cuivre, d'étain et de zinc par exemple par électroformage. L'alliage 5 est au moins partiellement revêtu par un matériau autre que l'alliage à base de cuivre, d'étain et de zinc. On comprend donc que le composant 1 peut être obtenu par un dépôt en surépaisseur d'un matériau autre que l'alliage 5, par exemple par galvanoplastie (dépôt électrolytique), par dépôt autocatalytique ou par dépôt en phase vapeur (physique ou chimique), sur tout ou partie d'une pièce en alliage 5 préalablement fabriquée. De fait, la pièce en alliage 5 à base de cuivre, d'étain et de zinc peut être uniquement partiellement ou totalement revêtue par un matériau autre que l'alliage 5 à base de cuivre, d'étain et de zinc.

Le matériau de revêtement peut être métallique (par exemple de l'or ou du rhodium) ou non (par exemple du silicium ou du carbone tel que du diamant ou du DLC) afin de permettre, par exemple, le passage et/ou la fixation d'un arbre, une amélioration esthétique (rugosité, couleur, etc.) ou une amélioration technique (dureté, tribologie, etc.). Comme pour le deuxième mode de réalisation, le revêtement dans le troisième mode de réalisation présente par exemple une épaisseur E₂ comprise entre 0,1 *µ*m et 10 *µ*m et, de manière préférée, entre 0,3 *µ*m et 5 *µ*m et, de manière encore plus préférée, entre 0,5 *µ*m et 2 *µ*m,.

Quel que soit le mode de réalisation, l'alliage 5 comporte préférentiellement une proportion de cuivre majoritaire en pourcentage de la masse totale de l'alliage 5, une proportion de zinc minoritaire en pourcentage de la masse totale de l'alliage 5 et une proportion d'étain, intermédiaire entre la proportion de cuivre et la proportion de zinc, en pourcentage de la masse totale de l'alliage 5. Ainsi, bien qu'il comporte une majorité de cuivre, l'alliage 5 présente un aspect gris métallique offrant une esthétique avantageuse, des caractéristiques élastiques (comme le module d'élasticité et la limite élastique) et une dureté étonnamment élevée pour un alliage à base de cuivre.

De manière préférée, la proportion de cuivre majoritaire est comprise entre 50 et 85 %, la proportion d'étain intermédiaire est comprise entre 10 et 40 % et la proportion de zinc minoritaire est comprise entre 2 et 15% et de manière encore plus préférée, la proportion de cuivre majoritaire est comprise entre 55 et 65%, la proportion d'étain intermédiaire est comprise entre 25 et 40% et la proportion de zinc minoritaire est comprise entre 4 et 10%.

L'alliage 5 est préférentiellement du type galvanique, c'est-à-dire obtenu à partir d'une galvanoplastie, afin d'améliorer sa dureté. Typiquement, une dureté comprise entre 400 et 700 HV 0,01, plus particulièrement au moins égale à 550 HV 0,01 peut être obtenue à partir d'un dépôt galvanique de l'alliage 5, cette dureté étant intrinsèque, c'est-à-dire obtenue sans traitement de durcissement particulier. Un traitement thermique peut permettre d'améliorer encore la dureté de l'alliage. En revanche, il a été trouvé que ce même alliage 5 comporte une dureté nettement inférieure quand il est fabriqué selon un autre procédé qu'une galvanoplastie. Toutefois, toute méthode de fabrication d'un tel alliage 5 ternaire peut être envisagée au vu de ses qualités.

À titre de comparaison, un alliage nickel-phosphore obtenu de manière galvanique présente une dureté autour de 600 HV 0,01, un module d'élasticité autour de 148 GPa et une limite élastique autour de 1900 MPa.

Selon une première variante, la proportion de cuivre majoritaire est sensiblement égale à 65 %, la proportion d'étain intermédiaire est sensiblement égale à 30 % et la proportion de zinc minoritaire est sensiblement égale à 5 %. Cette première variante, avec les mêmes essais que pour l'alliage nickel-phosphore, a permis d'obtenir des caractéristiques similaires à l'alliage nickel-phosphore.

Selon une deuxième variante, la proportion de cuivre majoritaire est sensiblement égale à 60 %, la proportion d'étain intermédiaire est sensiblement égale à 30 % et la proportion de zinc minoritaire est sensiblement égale à 10 %. Cette deuxième variante, avec les mêmes essais que pour l'alliage nickel-phosphore, a permis d'obtenir une dureté de 675 HV 0,01, un module d'élasticité de 161 GPa et une limite élastique de 2207 MPa. On comprend que cette deuxième variante possède de meilleures caractéristiques qu'un alliage nickel-phosphore.

Selon une troisième variante, la proportion de cuivre majoritaire est sensiblement égale à 57 %, la proportion d'étain intermédiaire est sensiblement égale à 39 % et la proportion de zinc minoritaire est sensiblement égale à 4 %. Cette troisième variante, avec les mêmes essais que pour l'alliage nickel-phosphore, a permis d'obtenir une dureté de 640 HV 0,01, un module d'élasticité de 160 GPa et une limite élastique de 2090 MPa. On comprend que cette troisième variante possède de meilleures caractéristiques qu'un alliage nickel-phosphore.

L'invention n'est pas limitée aux modes de réalisation et variantes présentés et d'autres modes de réalisation et variantes apparaîtront clairement à l'homme du métier. Ainsi, d'autres composés peuvent entrer dans la composition de l'alliage 5 sans sortir du cadre de l'invention pour permettre, par exemple, une plus grande stabilité ou une plus grande dureté comme, par exemple, du carbone, du silicium ou du manganèse. De plus, d'autres composés peuvent entrer dans la composition au titre d'impuretés, c'est-à-dire à des proportions inférieures ou égales à 0,5 % de la masse totale de l'alliage 5.

Optionnellement, au moins une couche d'adhérence peut être déposée entre la pièce 7 et l'alliage 5 du composant 1 pour en faciliter l'accrochage. Chaque couche d'adhérence, par exemple à base de chrome, de nickel ou d'or, peut ainsi jouer le rôle d'un élément d'accroché pour éviter notamment la délamination entre la pièce 7 et l'alliage 5 du composant 1. Bien entendu, avec ou sans couche d'adhérence, la surface de la pièce 7 ou de l'alliage 5 du composant 1 peut être nettoyée ou préparée d'une autre manière avant tout dépôt pour faciliter son accrochage.

En outre, suivant les applications, le composant 1 peut être utilisé avec ou sans lubrifiant pour encore améliorer ses qualités tribologiques.

De plus, au vu des avantages de l'alliage 5, ce dernier peut également être appliqué dans d'autres domaines tels que, par exemple, la bijouterie, la joaillerie, la maroquinerie, les arts de la table, les instruments d'optique, les armes à feu ou les instruments d'écriture.

## Revendications

1. Composant (1) pour une pièce d'horlogerie, qui comporte un alliage (5) du type galvanique ou du type dépôt autocatalytique à base de cuivre, d'étain et de zinc permettant des propriétés tribologiques améliorées le composant (1) étant formé à partir de l'alliage (5) qui comporte une proportion de cuivre majoritaire en pourcentage de la masse totale de l'alliage (5), une proportion de zinc minoritaire en pourcentage de la masse totale de l'alliage (5) et une proportion d'étain intermédiaire entre la proportion de cuivre et la proportion de zinc en pourcentage de la masse totale de l'alliage (5).

2. Composant (1) selon la revendication précédente, dans lequel la proportion de cuivre majoritaire est comprise entre 50 et 85 %, la proportion d'étain intermédiaire est comprise entre 10 et 40 % et la proportion de zinc minoritaire est comprise entre 2 et 15 %.

3. Composant (1) selon la revendication précédente, dans lequel la proportion de cuivre majoritaire est comprise entre 55 et 65 %, la proportion d'étain intermédiaire est comprise entre 25 et 40 % et la proportion de zinc minoritaire est comprise entre 4 et 10 %.

4. Composant (1) selon la revendication précédente, dans lequel la proportion de cuivre majoritaire est sensiblement égale à 65 %, la proportion d'étain intermédiaire est sensiblement égale à 30 % et la proportion de zinc minoritaire est sensiblement égale à 5 %.

5. Composant (1) selon la revendication 4, dans lequel la proportion de cuivre majoritaire est sensiblement égale à 60 %, la proportion d'étain intermédiaire est sensiblement égale à 30 % et la proportion de zinc minoritaire est sensiblement égale à 10 %.

6. Composant (1) selon la revendication 4, dans lequel la proportion de cuivre majoritaire est sensiblement égale à 57 %, la proportion d'étain intermédiaire est sensiblement égale à 39 % et la proportion de zinc minoritaire est sensiblement égale à 4 %.

7. Composant (1) selon l'une quelconque des revendications précédentes, dont l'épaisseur (E₁) est comprise entre 10 *µ*m et 1 mm.

8. Composant selon l'une quelconque des revendications précédentes, dans lequel l'alliage (5) est au moins partiellement revêtu par un matériau autre que l'alliage (5) à base de cuivre, d'étain et de zinc.

9. Composant selon l'une des revendications précédentes 1 à 7, entièrement formé à partir de l'alliage (5).

10. Pièce d'horlogerie (11) comportant au moins un composant (1), **caractérisée en ce que** le composant (1) est selon l'une des revendications précédentes.

11. Pièce d'horlogerie (11) selon la revendication précédente, dans laquelle le composant (1) est une pièce de micromécanique (3) ou une pièce d'habillage (13, 15).

## Patentansprüche

1. Bauteil (1) für eine Uhr, das eine Legierung (5) des galvanischen Typs oder des autokatalytischen Abscheidungstyps auf Kupfer-, Zinn- und Zinkbasis aufweist, die verbesserte tribologische Eigenschaften gestattet, wobei das Bauteil (1) aus der Legierung (5) gebildet ist, die an der Gesamtmasse der Legierung (5) einen prozentual größeren Anteil an Kupfer, an der Gesamtmasse der Legierung (5) einen prozentual kleineren Anteil an Zink und an der Gesamtmasse der Legierung (5) einen Anteil an Zinn, der zwischen dem Anteil an Kupfer und dem Anteil an Zink liegt, aufweist.

2. Bauteil (1) nach dem vorhergehenden Anspruch, wobei der größere Anteil an Kupfer zwischen 50 und 85 % beträgt, der dazwischenliegende Anteil an Zinn zwischen 10 und 40 % beträgt und der kleinere Anteil an Zink zwischen 2 und 15 % beträgt.

3. Bauteil (1) nach dem vorhergehenden Anspruch, wobei der größere Anteil an Kupfer zwischen 55 und 65 % beträgt, der dazwischenliegende Anteil an Zinn zwischen 25 und 40 % beträgt und der kleinere Anteil an Zink zwischen 4 und 10 % beträgt.

4. Bauteil (1) nach dem vorhergehenden Anspruch, wobei der größere Anteil an Kupfer im Wesentlichen gleich 65 % ist, der dazwischenliegende Anteil an Zinn im Wesentlichen gleich 30 % ist und der kleinere Anteil an Zink im Wesentlichen gleich 5 % ist.

5. Bauteil (1) nach Anspruch 4, wobei der größere Anteil an Kupfer im Wesentlichen gleich 60 % ist, der dazwischenliegende Anteil an Zinn im Wesentlichen gleich 30 % ist und der kleinere Anteil an Zink im Wesentlichen gleich 10 % ist.

6. Bauteil (1) nach Anspruch 4, wobei der größere Anteil an Kupfer im Wesentlichen gleich 57 % ist, der dazwischenliegende Anteil an Zinn im Wesentlichen gleich 39 % ist und der kleinere Anteil an Zink zwischen 2 und 4 % beträgt, der kleinere Anteil an Zink im Wesentlichen gleich 4 % ist.

7. Bauteil (1) nach einem der vorhergehenden Ansprüche, dessen Dicke (E₁) zwischen 10 µm und 1 mm beträgt.

8. Bauteil nach einem der vorhergehenden Ansprüche, wobei die Legierung (5) mindestens teilweise mit einem anderen Material als die Legierung (5) auf Kupfer-, Zinn- und Zinkbasis beschichtet ist.

9. Bauteil nach einem der vorstehenden Ansprüche 1 bis 7, das zur Gänze aus der Legierung (5) gebildet ist.

10. Uhr (11), aufweisend wenigstens ein Bauteil (1), **dadurch gekennzeichnet, dass** das Bauteil (1) nach einem der vorhergehenden Ansprüche ausgestaltet ist.

11. Uhr (11) nach dem vorhergehenden Anspruch, wobei das Bauteil (1) ein feinstmechanisches Teil (3) oder ein Gehäuseteil (13, 15) ist.

## Claims

1. Timepiece component (1), which comprises an alloy (5) of galvanic type or autocatalytic deposition type based on copper, tin and zinc providing improved tribological properties, the component (1) being formed from the alloy (5) which comprises a majority proportion of copper as a percentage of the total weight of the alloy (5), a minority proportion of zinc as a percentage of the total weight of the alloy (5) and an intermediate proportion of tin between the proportion of copper and the proportion of zinc as a percentage of the total weight of the alloy (5).

2. Component (1) according to the preceding claim, wherein the majority proportion of copper is between 50 % and 85 %, the intermediate proportion of tin is between 10 % and 40 % and the minority proportion of zinc is between 2 % and 15 %.

3. Component (1) according to the preceding claim, wherein the majority proportion of copper is between 55 % and 65 %, the intermediate proportion of tin is between 25 % and 40 % and the minority proportion of zinc is between 4 % and 10 %.

4. Component (1) according to the preceding claim, wherein the majority proportion of copper is substantially equal to 65 %, the intermediate proportion of tin is substantially equal to 30 % and the minority proportion of zinc is substantially equal to 5 %.

5. Component (1) according to claim 4, wherein the majority proportion of copper is substantially equal to 60 %, the intermediate proportion of tin is substantially equal to 30 % and the minority proportion of zinc is substantially equal to 10 %.

6. Component (1) according to claim 4, wherein the majority proportion of copper is substantially equal to 57 %, the intermediate proportion of tin is substantially equal to 39 % and the minority proportion of zinc is substantially equal to 4 %.

7. Component (1) according to any one of the preceding claims, whose thickness (E₁) is between 10 µm and 1 mm.

8. Component according to any one of the preceding claims, wherein the alloy (5) is at least partially coated with a material other than the alloy (5) based on copper, tin and zinc.

9. Component according to one of the preceding claims 1 to 7, made entirely of the alloy (5).

10. Timepiece (11) comprising at least one component (1), **characterised in that** the component (1) is according to one of the preceding claims.

11. Timepiece (11) according to the preceding claim, wherein the component (1) is a micromechanical part (3) or an external part (13, 15).
